# EUROPÄISCHE PATENTANMELDUNG

(11) **EP 1 335 423 A2**
(43) Veröffentlichungstag der Anmeldung: **13.08.2003**
(21) Anmeldenummer: 03002386.5
(22) Anmeldetag: 04.02.2003
(51) Int. Cl.: H01L 21/66

(54) **Verfahren zur Erkennung von Beschädigungen an IC-Bauelementen**

(30) Priorität: 08.02.2002 DE 10205517
(71) Anmelder: Orga Kartensysteme GmbH, 33104 Paderborn (DE)
(72) Erfinder: Osterwald, Frank, Dr., 24103 Kiel (DE)

(57) **Zusammenfassung**

Es wird ein Verfahren zur Erkennung von mechanischen Beschädigungen an IC-Bauelementen vorgestellt, mit dem erstmals die bei der Vereinzelung der IC-Bauelemente in Folge mechanischer Beanspruchung auftretenden Schädigungen gemessen und in nachgeschaltete Steuer- und Regelvorgänge umgesetzt werden können. Das Verfahren zeichnet sich erfindungsgemäß dadurch aus, dass eine Aufnahmeeinheit zur Messung von Schallemissionen unmittelbar am zu prüfenden Bauelement angeordnet wird, dass während des Vereinzelungsvorganges für die auf einer gemeinsamen Waferfolie angeordneten IC-Bauelemente die durch die Vereinzelungsvorrichtungen am IC-Bauelement hervorgerufenen Schallemissionen gemessen werden, dass die gemessenen Schallemissionen einer Rechnerauswerteeinheit zugeleitet werden, welche die Schallemissionen mit normierten gespeicherten Schallemissionskurven vergleicht und dass bei Lage der gemessenen Schallemissionen außerhalb eines um ein Toleranzfeld erweiterten Kurvenbereiches der normierten gespeicherten Schallemissionen das geprüfte IC-Bauelement aus dem Bearbeitungsprozess entfernt wird.

Mit Hilfe des erfindungsgemäßen Verfahrens lässt sich die Ausschussrate bei der Verarbeitung von IC-Bauelementen u. a. bei der Herstellung von Chipmodulen und Datenträgerkarten maßgeblich herabsetzen.

## Beschreibung

Die Erfindung betrifft ein Verfahren gemäß dem Gattungsbegriff des Patentanspruches 1.

Die dort genannten IC-Bauelemente, welche auch als Chips bezeichnet werden, finden je nach Verwendungszweck in unterschiedlicher Ausgestaltung auf sogenannten Datenträger- oder Chipkarten Verwendung, sind jedoch auch für andere Einsatzzwecke verwendbar.

Die Herstellung derartiger IC-Bauelemente geschieht mittels so genannter Waferfolien aus die Bauelemente bildendem Halbleitermaterial. Diese Waferfolien weisen insbesondere in der Chipkartenindustrie unter den augenblicklich üblichen Rahmenbedingungen eine Dicke von 185 µm bis zu 150 µm auf. Allerdings sind zukünftig auch noch dünnere Waferfolien im Bereich von 120 µm bis 100 µm denkbar. Die Herstellung bzw. Vereinzelung der auf der Waferfolie befindlichen IC-Bauelemente geschieht üblicherweise durch eine festgelegte Abfolge von einzelnen Verfahrensschritten.

Zunächst wird die Waferfolie auf eine Trägerfolie aufgespannt, welche ihrerseits in einem Rahmen, dem so genannten Waferframe, gehalten ist. In diesem Herstellungsstadium befindet sich die Waferfolie noch in ungeteilten Zustand. Nach dem Aufspannen der Waferfolie wird diese üblicherweise mittels eines oder mehrerer Sägevorgänge oder mittels anderer Trennverfahren in Segmente geteilt, die die einzelnen IC-Bauelemente bilden.

Die auf diese Weise vereinzelten Chips können anschließend von der Trägerfolie abgenommen und auf einem Trägerelement oder Substrat aufgesetzt werden, wobei das Substrat zusammen mit dem aufgesetzten, elektrisch kontaktierten und eventuell durch einen Verguss geschützten Chip ein in Chipkarten einzusetzendes so genanntes Chipmodul bildet. Die Aufnahme der vereinzelten IC-Bauelemente von der Trägerfolie erfolgt üblicherweise durch einen kombinierten Verfahrensschritt dergestalt, dass die einzelnen Bauelemente von unten durch ein oder mehrere Ausstoßnadeln angehoben werden und gleichzeitig in einem synchronisierten Prozessschritt von oben durch ein Vakuum-Saugwerkzeug (Pick-Up Tool) aufgenommen werden. Das Vakuum-Saugwerkzeug setzt anschließend die einzelnen an ihm festgelegten IC-Bauelemente jeweils auf einem zugehörigen einzelnen Trägerelement positionsgenau ab, wobei gleichzeitig eine Fixierung des IC-Bauelementes mittels eines auf dem Trägerelement vorhandenen Klebstoffpunktes erfolgen kann.

Bei der geschilderten Vereinzelung der möglicherweise schon zum Beispiel durch Sägeprozesse vorgeschädigten IC-Bauelemente einschließlich der Anordnung auf hierfür vorgesehenen Trägerelementen ergeben sich verschiedene Fehlerquellen, durch die die fertigen Chipmodule so geschädigt werden können, dass eine Weiterverarbeitung bzw. ein Einsatz ausscheidet.

Zwei wesentliche Fehlerquellen bestehen zum einen in einer ungenauen Positionierung der IC-Bauelemente auf dem Trägerelement sowie zum anderen durch eine mechanische Schädigung der IC-Bauelemente während des Aufnahmeprozesses von der Trägerfolie mittels der Ausstoßnadeln und des Vakuum-Saugwerkzeuges. Die durch die genannte erste möglichen Fehlerquelle hervorgerufene Schädigung der Chipmodule lässt sich mittels moderner Bilderkennungssysteme dahingehend beeinflussen, dass in ihrer Position fehlerhaft auf dem Trägerelement abgelegte IC-Bauelemente zuverlässig erkannt und von der Weiterverarbeitung ausgeschlossen werden können.

Für die Erkennung von Schädigungen des IC-Bauelementes in Folge mechanischer Beanspruchungen des Halbleitermaterials während des Vereinzelungs- bzw. Aufnahmeprozesses der IC-Bauelemente sind demgegenüber aus dem Stand der Technik nur sehr aufwendige und in der Regel zerstörende Verfahren bekannt.

Diese bekannten Verfahren lassen sich nicht in den Herstellungsablauf für die Chipmodule integrieren, so dass Schädigungen der IC-Bauelemente, beispielsweise Mikrorisse oder Abdrücke der Ausstoßnadeln nur durch stichprobenhafte Entnahme einzelner IC-Bauelemente aus dem Produktionsprozess mit anschließender zerstörender Prüfung erkannt werden kann, wobei eine positive Prüfung der IC-Bauelemente naturgemäß nur indirekte Rückschlüsse auf die Unversehrtheit nicht geprüfter IC-Bauelemente zulässt.

Aufgabe der vorliegenden Erfindung ist es, ein Verfahren der eingangs geschilderten Art bereitzustellen, welches auf einfache und zuverlässige Art eine Prüfung der IC-Bauelemente auf mechanische Schädigungen zulässt, wobei das Verfahren sich auf Grund seiner Konzeption in vorhandene Produktionslinien eingliedern lassen soll.

Diese Aufgabe wird erfindungsgemäß durch die im kennzeichnenden Teil des Anspruches 1 offenbarte technische Lehre gelöst. Wesentliche erfindungsgemäße Verfahrensschritte sind hierbei, dass eine Aufnahmeeinheit zur Messung von Schallemissionen unmittelbar am zu prüfenden IC-Bauelement angeordnet wird, dass während des Vereinzelungsvorganges für die auf einer gemeinsamen Waferfolie angeordneten IC-Bauelemente die durch das Einwirken der Vereinzelungsvorrichtungen auf das IC-Bauelement hervorgerufenen Schallemissionen gemessen werden, dass die gemessenen Schallemissionen einer Rechnerauswerteeinheit zugeleitet werden, welche die Schallemissionen mit normierten gespeicherten Schallemissionskurven vergleicht und dass bei Lage der gemessenen Schallemissionen außerhalb eines um ein Toleranzfeld erweiterten Kurvenbereiches der normierten gespeicherten Schallemissionen das geprüfte IC-Bauelement aus dem weiteren Bearbeitungsprozess entfernt wird.

Das erfindungsgemäße Verfahren macht sich hierbei zunutze, dass die bei der Aufnahme der IC-Bauelemente hervorgerufenen Schallemissionen, die sich in Folge des Anstoßes durch die Ausstoßnadel bzw. dem Ansaug- und Halteprozess durch das Vakuum-Saugwerkzeug innerhalb des IC-Bauelement ergeben, unterschiedlich darstellen, je nachdem, ob das betreffende Bauelement intakt ist oder eine Schädigung in Folge von Mikrorissen oder anderer mechanischer Unzulänglichkeiten aufweist.

Aus der Literatur sind in diesem Zusammenhang akustische Messverfahren bekannt geworden, bei denen die Anbindung von Bonddrähten an die Kontaktflächen von Chipmodulen mittels eigens entwickelter Messverfahren geprüft werden kann. Das beim Verbindungsprozess entstehende Geräuschspektrum kann in diesem Zusammenhang eine Abhängigkeit zwischen der Qualität der Verbindung zwischen Kontaktfläche und Bonddraht dokumentieren. Zur näheren Erläuterung wird hierbei auf den Aufsatz von K.V. Raben mit dem Titel "Überwachung des TC-Bondens mittels Schallemissionsanalyse" auf dem internationalen Kolloquium in Fellbach im Jahres 1986 verwiesen.

Besondere Ausgestaltungen des erfindungsgemäßen Verfahrens ergeben sich in Zusammenschau mit der technischen Lehre des Anspruches 1 aus den Merkmalen der Unteransprüche.

Für die Messung der Schallemissionen lassen sich vorteilhafterweise piezoelektrische Schallaufnehmer nutzen, da diese hinsichtlich Zuverlässigkeit, Empfindlichkeit und finanziellen Aufwand für deren Beschaffung eine besonders vorteilhafte Realisierung der Aufnahmeeinheit zur Messung der hervorgerufenen Schallemissionen darstellen. Die betreffende Aufnahmeeinheit lässt sich dabei zweckmäßig beispielsweise in der Aufnahme für die Ausstoßnadeln oder in das sogenannte Pick-Up-Tool integrieren. Dieses Pick-Up-Tool ist Bestandteil des ... und dient dazu, ... integrieren.

Die nachgeschaltete Auswertung der gemessenen Schallemissionen durch die Rechnerauswerteeinheit kann bei entsprechend schneller Signalverarbeitung eine unmittelbare Auslese der beschädigten IC-Bauelemente aus dem Verarbeitungsprozess ermöglichen. Darüber hinaus kann die schnelle Signalauswertung für Regelvorgänge genutzt werden, um beispielsweise ein zu hartes Auftreffen der Ausstoßnadeln auf der IC-Bauelementrückseite nachzuregeln und damit die Ausschussquote bei den IC-Bauelementen zu senken. Eine vereinfachte Möglichkeit der Herstellprozessbeeinflussung besteht darin, für die gemessenen Schallemissionswerte innerhalb der Rechnerauswerteeinheit einen Schwellwert zu definieren, bei dessen Überschreitung davon ausgegangen werden kann, dass die betreffenden IC-Bauelemente in Folge der mechanischen Belastung in irgendeiner Weise so weit geschädigt sind, dass eine Weiterverarbeitung unvorteilhaft erscheint.

Im Rahmen des Herstellprozesses auf einer integrierten Produktionslinie werden naturgemäß zahlreiche Störgeräusche hervorgerufen, die die Messung der relevanten Schallemissionen zumindest erschweren. Um hier Abhilfe zu schaffen, kann es vorteilhaft sein, die jeweils richtigen Frequenzanteile aus den gemessenen Schallemissionswerten durch Bandpassfilter herauszufiltern. Sollten Störschallemissionen im gleichen Frequenzbereich wie die für die Auffindung von Schädigungen an IC-Bauelementen relevanten Frequenzen auftreten, so besteht darüber hinaus die Möglichkeit, die Nutzsignale durch das Einmischen entsprechender Antischallsignale der Störemission aufzubereiten. Durch die geschilderten Merkmalskombinationen der erfindungsgemäßen technischen Lehre ist es somit möglich, gezielt die Ausschussrate bei der Verarbeitung bzw. Vereinzelung von IC-Bauelementen in Folge mechanischer Beanspruchungen erheblich herabzusetzen, was sich wiederum positiv auf die Herstellpreise von Chipmodulen bzw. der damit ausgestatteten Chipkarten auswirkt.

Insbesondere ist von Vorteil, dass bei einer entsprechend schnellen Signalverarbeitung der gemessenen Schallemissionen die Schädigung weiterer IC-Bauelemente durch Parameteranpassung des Aufnahmeprozesses derartiger Elemente maßgeblich reduziert werden kann.

## Patentansprüche

1. Verfahren zur Erkennung von mechanischen Beschädigungen an IC-Bauelementen, **dadurch gekennzeichnet, dass**
- eine Aufnahmeeinheit zur Messung von Schallemissionen unmittelbar am zu prüfenden IC-Bauelement angeordnet wird, dass während des Vereinzelungsvorganges für die auf einer gemeinsamen Waferfolie angeordneten IC-Bauelemente die durch Einwirken der Vereinzelungsvorrichtungen auf das IC-Bauelement hervorgerufenen Schallemissionen gemessen werden,
- dass die gemessenen Schallemissionen einer Rechnerauswerteeinheit zugeleitet werden, welche die Schallemissionen mit normierten gespeicherten Schallemissonskurven vergleicht,
- dass bei Lage der gemessenen Schallemissionen außerhalb eines um ein Toleranzfeld erweiterten Kurvenbereiches der normierten gespeicherten Schallemissionskurven das geprüfte IC-Bauelement aus dem Bearbeitungsprozess für das IC-Bauelement entfernt wird.

2. Verfahren nach Anspruch 1, **dadurch gekennzeichnet, dass** die gemessenen Schallemissionen über Bandpassfilter von zusätzlich beim Vereinzelungsvorgang auftretenden Störgeräuschen selektiert werden.

3. Verfahren nach Anspruch 1 oder 2, **dadurch gekennzeichnet, dass** bei Lage der gemessenen Schallemissionen außerhalb eines um ein Toleranzfeld erweiterten Kurvenbereiches der normierten gespeicherten Schallemissionen eine Regelung der für den Vereinzelungsvorgang der IC-Bauelemente auf der gemeinsamen Waferfolie maßgeblichen Vorrichtungen wie Ausstoßnadeln und Vakuumsaugwerkzeuge erfolgt.

4. Verfahren nach einem der vorgenannten Ansprüche 1 bis 3, **dadurch gekennzeichnet, dass** die Aufnahmeeinheit zur Messung von Schallemissionen als piezoelektrische Aufnahmeeinheit ausgebildet ist.

5. Verfahren nach einem der Ansprüche 1 bis 4, **dadurch gekennzeichnet, dass** innerhalb der Rechnerauswerteeinheit mindestens ein Schwellwert gespeichert ist, und dass bei Lage der gemessenen Schallemissionen oberhalb des gespeicherten Schwellwertes das geprüfte IC-Bauelement aus dem Bearbeitungsprozess entfernt wird.
